Europäisches Patentamt

European Patent Office

Office européen des brevets

(19)

(11) Numéro de publication: **0 154 572**
**B1**

(12) **FASCICULE DE BREVET EUROPEEN**

(45) Date de publication du fascicule du brevet:
26.07.89

(51) Int. Cl.⁴: **H 05 K 3/07, C 25 F 3/14**

(21) Numéro de dépôt: 85400162.5

(22) Date de dépôt: 31.01.85

(54) Procédé de formation de circuits électriques en couche mince, outil pour la mise en oeuvre du procédé, et produits obtenus.

(30) Priorité: 20.02.84 FR 8402490

(43) Date de publication de la demande:
11.09.85 Bulletin 85/37

(45) Mention de la délivrance du brevet:
26.07.89 Bulletin 89/30

(84) Etats contractants désignés:
BE CH DE FR GB IT LI LU NL SE

(56) Documents cités:
FR-A- 977 587
FR-A- 1 584 726
FR-A- 1 585 169
GB-A- 805 291
GB-A- 972 048
GB-A- 1 225 676
US-A- 3 634 203

(73) Titulaire: SOLEMS S.A. Société dite:, 3, rue Léon Blum
Z.I. Les Glaises, F-91120 Palaiseau (FR)

(72) Inventeur: Solomon, Ionel, 56, rue de Sèvres,
F-92100 Boulogne (FR)
Inventeur: Meot, Jacques, 95, rue du Commerce,
F-75015 Paris (FR)
Inventeur: Meligne, Patrick, 11, allée des Saules,
F-91540 Mennecy (FR)

(74) Mandataire: Lerner, François, 5, rue Jules Lefèbvre,
F-75009 Paris (FR)

## Description

La présente invention se rapporte à la formation de circuits électriques composés d'une couche mince conductrice ou semi-conductrice déposée sur un substrat isolant électrique.

On connaît divers procédés de formation de circuits électriques du type précité.

Selon un procédé connu, on utilise des masques permettant de protéger la couche mince conductrice ou semi-conductrice sur certaines plages et permettant de l'attaquer selon le motif prédéterminé; ce procédé met fréquemment en œuvre des techniques photographiques; les opérations de fabrication des circuits sont cependant relativement compliquées et d'autre part, manquent de souplesse dans la réalisation des circuits qui sont tributaires de la réalisation des masques.

Selon un autre procédé connu, pouvant donner d'ailleurs de bons résultats, on utilise des techniques laser pour détruire précisément aux endroits voulus la couche mince conductrice ou semi-conductrice déposée sur son substrat; cette technique permet de dessiner précisément des circuits; elle présente l'inconvénient de nécessiter un appareillage coûteux.

On connaît également des techniques d'enlèvement de matière, par exemple par électro-érosion, permettant de réaliser des circuits imprimés conducteurs formés dans une couche métallique mince déposée sur un substrat isolant; ces techniques sont limitées à la nature conductrice de la couche mince, généralement du cuivre, et ne permettent pas de déterminer précisément les caractéristiques de la coupure ni d'obtenir de part et d'autre de cette coupure une isolation renforcée.

Le brevet GB-A-1 225 676 se classe dans cette dernière catégorie. Il enseigne un procédé d'attaque par électro-érosion d'une couche métallique permettant notamment de former, par gravage dans cette couche, des motifs pour circuits électriques.

Mais dans ce document il n'est question que d'enlèvement local de la matière conductrice, de manière à laisser sur le substrat les circuits conducteurs imprimés. De plus, les motifs formés sont répétitifs.

C'est dans ce contexte et manière à éviter les inconvénients sus-mentionnés que l'invention a pour objet de permettre, à partir d'un appareillage simple, peu coûteux, facile à mettre en œuvre, la réalisation de circuits électriques de toute configuration souhaitée et d'excellente qualité, notamment d'isolation électrique.

A cet effet, le procédé de formation de circuits électriques composés d'une couche mince conductrice ou semi-conductrice déposée sur un substrat isolant électrique, du type dans lequel on part d'une couche mince continue, déposée sur le substrat et dans laquelle on réalise ensuite, par une technique d'électro-érosion, des découpes, attaques ou enlèvements pour former ledit circuit, se caractérise selon l'invention en ce qu'on effectue lesdites opérations de découpe, attaque ou enlèvement dans un milieu dont la composition est choisie de façon que sous l'action du micro-arc électrique formé dans ce milieu, entre la pointe d'un outil d'électro-érosion et ladite couche mince conductrice, il y ait à cet endroit, formation d'un nouveau composé chimique, lequel composé est isolant électrique.

Ainsi, par un choix électrochimique ou diélectrique approprié du milieu, associé à la couche mince conductrice ou semi-conductrice utilisée, il va être possible au moyen d'une technique d'électro-érosion très simple à mettre en œuvre, de former dans ladite couche mince, tous motifs de circuits désirés et parfaitement isolés par une sorte de cordon isolant ainsi fabriqué in situ.

Outre le procédé que l'on vient d'évoquer, on notera que l'invention a également pour objet un circuit électrique réalisé, au moyen d'un outil d'électro-érosion, dans une plaque comportant une couche mince conductrice ou semi-conductrice déposée sur un substrat isolant électrique, caractérisé en ce qu'il comprend formé dans ladite couche mince et aux endroits où l'outil d'électro-érosion a été appliqué, un composé chimique formant isolant électrique.

Et un troisième objet de l'invention est un outil pour la mise en œuvre du procédé énoncé ci-avant qui se caractérise en ce qu'il comprend au moins un galet sur lequel passe, en étant tendu entre une bobine d'approvisionnement et une bobine de reprise, un fil métallique dépassant la surface dudit galet et formant parallèlement à sa longueur la pointe d'électro-érosion précitée.

Mais l'invention et sa mise en œuvre apparaîtront plus clairement à l'aide de la description qui va suivre faite en référence aux dessins annexés illustrant:

– figure 1, de façon schématique, une possibilité de mise en œuvre de l'invention;

– figure 2, de façon schématique, un outil approprié à la mise en œuvre du procédé;

– figure 3, une coupe à travers la pointe de l'outil, faite sensiblement dans le plan III–III de la figure 2;

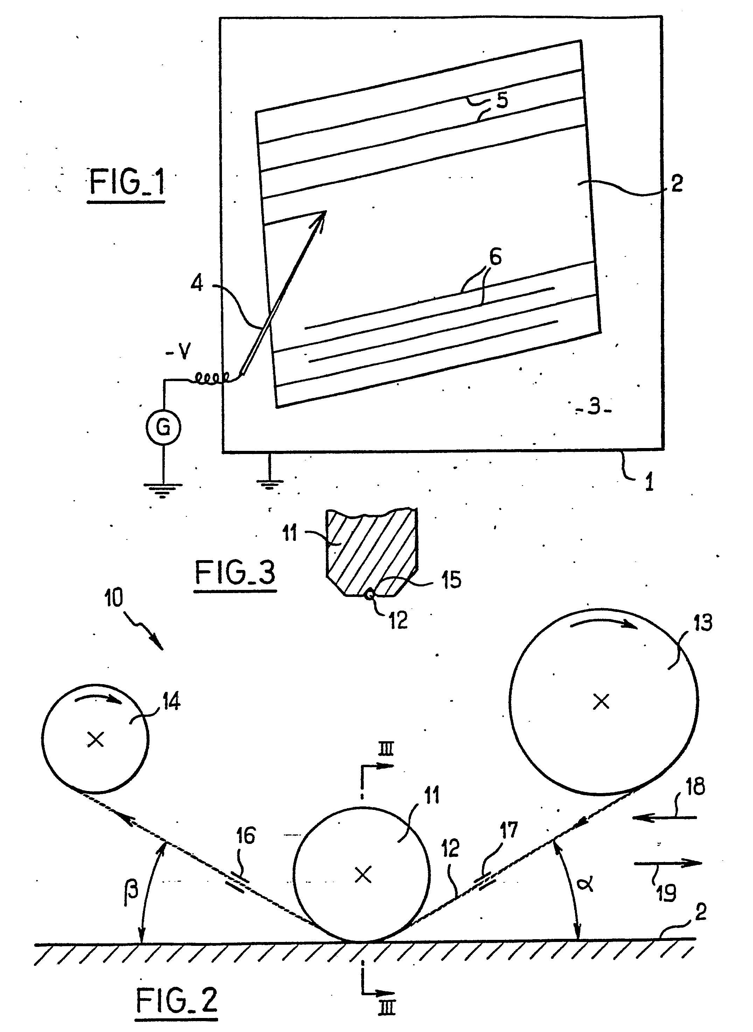

Selon l'exemple de réalisation schématisé à la figure 1, on a placé à l'intérieur d'une cuve 1, une plaque 2 plongée dans un milieu 3 formé par un liquide diélectrique ou un électrolyte. La plaque 2 est par exemple une plaque comportant un substrat en verre sur lequel a été déposée une couche mince conductrice ou semi-conductrice, par exemple de $SnO_2$ ou d'oxyde d'indium dopé à l'étain, en abréviation: ITO (pour «indium tin oxide»). Ces couches peuvent avoir une épaisseur par exemple comprise entre 700 et 8000 angström (Å) (soit $7.10^{-5}$ mm à $8.10^{-4}$ mm).

Le dépôt peut avoir été obtenu par tout moyen approprié tel que dépôt chimique, enduction, projection sous vide, évaporation, pulvérisation, etc..

D'autre part, on relie l'outil d'électro-gravure, par exemple un stylet conducteur électrique 4, à une source négative de tension – V d'un générateur G dont la masse est reliée, soit à la cuve, soit à la couche à graver.

Dans l'exemple illustré, le milieu dans lequel s'effectue la réaction est de l'eau.

Pour obtenir l'attaque par électro-gravure de la couche mince conductrice ou semi-conductrice, on applique la pointe de l'électrode 4 sur la plaque et on l'y déplace selon le chemin désiré, par exemple des lignes telles que 5 traversant la plaque de part en part pour former des circuits séparés en parallèle, soit des lignes telles que 6 venant alternativement déboucher sur une tranche et sur l'autre de la plaque pour former un circuit en série, soit selon tout autre motif désiré. Dans l'exemple illustré, les lignes 5, 6 constituent des cordons d'isolation, dont la nature chimique semble complexe mais dont la résistance est toujours supérieure à $2.10^6$ ohms. Pour des couches dont la résistance par unité de surface est comprise entre 10 et 50 ohms, les tensions minimales (tensions de seuil) sont en moyenne de l'ordre de 40 volts et les courants mis en jeu sont compris entre 30 et 140 mA.

Pour les couches dont la résistance par unité de surface est supérieure à 50 ohms, les tensions de seuil varient de 60 à 150 V; cependant, les courants mis en jeu restent compris entre 30 et 150 mA.

La largeur des rayures dépend directement de la tension de gravure, de la vitesse de déplacement et du profil de l'outil. Elle est généralement comprise entre 50 et 200 microns, les rayures les plus fines étant obtenues sur les couches ayant les plus grandes résistances par unité de surface.

Quel que soit le type de matériau à graver, l'isolation de part et d'autre d'une rayure par le cordon isolant formé est supérieure à $2.10^6$ ohms.

Si l'on utilise un électrolyte ou un liquide diélectrique, ou un gel mouillant suffisamment bien la couche à graver, ou encore un film sec, il est possible de ne pas utiliser de cuve, pourvu que le milieu dans lequel se fait l'électro-érosion favorise la formation au niveau de la couche conductrice ou semi-conductrice du cordon isolant. On suppose qu'au niveau de ce film, on obtient un phénomène de stabilisation de l'arc d'électro-érosion et également une participation à la réaction chimique de modification de nature de la couche à traiter conduisant à la formation d'un cordon d'isolation au niveau de la coupure créée par l'électro-érosion.

Comme milieu, on peut utiliser un mélange d'eau/éthanol qui forme un film mouillant bien la couche à attaquer. Dans ce cas, il suffit de relier une bande du générateur G par exemple la masse, à la couche à graver, et l'autre bande du générateur à l'outil 4 dont la pointe est appliquée sur la plaque. Le micro-arc électrique formé à cet endroit par réaction électro-chimique avec l'électrolyte eau-éthanol la couche mince semi-conductrice réalisant le circuit souhaité.

Bien entendu, plusieurs outils peuvent être utilisés en parallèle, et ceux-ci peuvent prendre diverses formes telles que fil, lame ou tout autre objet conducteur dont une faible section pourra être appliquée sur une certaine longueur de la couche conductrice ou semi-conductrice à attaquer.

Un exemple particulièrement approprié d'outil est illustré schématiquement aux figures 2 et 3.

L'outil repéré dans son ensemble 10 comprend essentiellement un galet isolant électrique 11 sur lequel passe un fil métallique 12 tendu entre une bobine d'approvisionnement 13 du fil et une bobine 14 de reprise du fil. La section du fil métallique 12 et la gorge 15 formée dans le galet 13 ont des sections choisies de manière que le fil 12 fasse saillie sous la face inférieure du galet 11 comme il apparaît clairement à la figure 3. Le fil est avantageusement guidé à l'entrée et à la sortie du galet 11 par des guides-fils 16, 17. Les angles α, β, que forme le fil avec la surface de la plaque 2 à attaquer peuvent être par exemple de l'ordre de 30°.

Dans un exemple de réalisation, le fil métallique avait un diamètre variant entre 8 et 12 centièmes de millimètre et il dépassait sur environ la moitié de son diamètre en saillie sous la surface du galet 11.

L'ensemble du galet 11 et des bobines 13 et 14 est monté sur une platine support (non représentée). Dans la pratique, on appliquera l'outil, et donc le fil 12 contre la plaque 2 et on déplacera l'outil parallèlement à la longueur du fil, c'est-à-dire dans le sens des flèches 18 et 19 pour former les rayures isolantes dans la plaque 2. Le principe du fil approvisionné permet, après exécution de chaque rayure par déroulement du fil sur $^1/_2$ à 1 millimètre d'obtenir immédiatement une nouvelle pointe d'outil neuve. La pression d'application peut être comprise entre 100 et 700 grammes, la tension du fil peut être maintenue entre 50 et 500 grammes. La forme incurvée de la pointe de l'outil s'enroulant autour du galet 3 favorise l'utilisation de l'outil et permet de compenser les défauts de planéité du substrat. Avec une plaque 2 recouverte d'une couche de $SnO_2$, de bons résultats ont été obtenus en utilisant une tension d'alimentation sur la pointe de l'outil de 100 volts et en utilisant comme milieu diélectrique de réaction une fine pellicule d'eau. Les courants mis en œuvre sont de l'ordre de 100 milliampères.

**Revendications**

1. Procédé de formation de circuits électriques composés d'une couche mince conductrice ou semi-conductrice déposée sur un substrat isolant électrique du type dans lequel on part d'une couche mince continue, déposée sur le substrat et dans laquelle on réalise ensuite par une technique d'électro-érosion des découpes, attaques ou enlèvements, pour former ledit circuit caractérisé en ce qu'on effectue lesdites opérations de découpe, attaque ou enlèvement, dans un milieu dont la composition est choisie de façon que sous l'action du micro-arc électrique formé dans ce milieu, entre la pointe d'un outil d'électro-érosion (4) et ladite couche mince conductrice, il y ait à cet endroit formation d'un nouveau composé chimique, lequel composé est isolant électrique.

2. Procédé selon la revendication 1, caractérisé en ce que ledit milieu est un électrolyte ou un liquide diélectrique favorisant la formation dudit composé.

3. Procédé selon la revendication 1 ou la revendication 2, caractérisé en ce que, pour obtenir le motif désiré (5, 6) du circuit, on déplace relativement l'un par rapport, l'autre le substrat (2) et l'outil (4) d'électro-érosion.

4. Procédé selon l'une des revendications précédentes, caractérisé en ce que l'on ajuste la tension du travail de l'outil en fonction de la résistance électrique par unité de surface de la couche conductrice.

5. Procédé selon l'une des revendications précédentes, caractérisé en ce qu'on règle la largeur des rayures ou découpes formées par l'outil dans la couche mince en jouant sur la résistance électrique par unité de surface de ladite couche, la forme de l'outil, sa vitesse de déplacement et sur la tension d'attaque.

6. Procédé selon l'une des revendications précédentes, caractérisé en ce qu'on utilise, comme couche mince $SnO_2$ ou ITO (oxyde d'indium dopé à l'étain).

7. Procédé selon l'une des revendications précédentes, caractérisé en ce que la couche mince a une épaisseur comprise entre $7 \cdot 10^{-5}$ mm et $8 \cdot 10^{-4}$ mm environ.

8. Procédé selon l'une des revendications précédentes, caractérisé en ce que la couche mince est déposée sur un substrat en verre.

9. Procédé selon l'une des revendications précédentes, caractérisé en ce qu'on utilise, comme milieu précité, essentiellement de l'eau, éventuellement additionnée d'un peu d'éthanol.

10. Procédé selon l'une des revendications précédentes, caractérisé en ce qu'on utilise des tensions de travail comprises entre 40 et 150 V environ et des intensités de courant comprises entre 30 et 150 mA environ.

11. Outil pour la mise en œuvre du procédé selon l'une des revendications précédentes, caractérisé en ce qu'il comprend au moins un galet sur lequel passe, en étant tendu entre une bobine d'approvisionnement et une bobine de reprise, un fil métallique dépassant la surface dudit galet et formant parallèlement à sa longueur la pointe d'électro-érosion précitée.

12. Circuit électrique réalisé, au moyen d'un outil (10) d'électro-érosion, dans une plaque (2) comportant une couche mince conductrice ou semi-conductrice déposée sur un substrat isolant électrique, caractérisé en ce qu'il comprend, formé dans ladite couche mince et aux endroits (5, 6) où l'outil d'électro-érosion a été appliqué, un composé chimique formant isolant électrique.

13. Circuit électrique selon la revendication 12, caractérisé en ce que la couche mince est composée de $SnO_2$ ou d'iTO (oxyde d'Indium dopé à l'étain) et en ce que le substrat est en verre.

## Claims

1. A method of making up electric circuits consisting of a thin conductive or semi-conductive coating deposited on an electrically insulating substrate of the type in which the starting point is a continuous thin coating deposited on the substrate and in which cut-outs, gates or clearances are then made by an electro-erosion technique in order to form the said circuit, characterised in that the said cutting, gate making or removal operations are performed in a medium the composition of which is so selected that under the action of the electric micro-arc formed in this medium, between the tip of an electro-erosion tool (4) and the said thin conductive coating, a new chemical compound forms at this location and is electrically insulating.

2. A method according to Claim 1, characterised in that the said medium is an electrolyte or a dielectric liquid which encourages the formation of the said compound.

3. A method according to Claim 1 or Claim 2, characterised in that in order to achieve the desired pattern (5, 6) of the circuit, the substrate (2) and the electro-erosion tool (4) are displaced in relation to each other.

4. A method according to one of the preceding Claims, characterised in that the working voltage of the tool is adjusted as a function of the electrical resistance per unit of surface area of the conductive coating.

5. A method according to one of the preceding Claims, characterised in that the width of the lines or cuts formed by the tool in the thin coating is adjusted by regulating the electrical resistance per unit of surface area of the said coating, the shape of the tool, its speed of travel and the voltage which is applied.

6. A method according to one of the preceding Claims, characterised in that $SnO_2$ or ITO (indium oxide doped with tin) is used as the thin coating.

7. A method according to one of the preceding Claims, characterised in that the thickness of the thin coating is comprised between $7 \cdot 10^{-5}$ mm and $8 \cdot 10^{-4}$ mm approx.

8. A method according to one of the preceding Claims, characterised in that the thin coating is deposited on a glass substrate.

9. A method according to one of the preceding Claims, characterised in that essentially water to which possibly a little ethanol is added, is used as the aforesaid medium.

10. A method according to one of the preceding Claims, characterised in that working voltages are used which range between approx. 40 and 150 V and current strengths which range between approx. 30 and 150 mA.

11. A tool for carrying out the method according to one of the preceding Claims, characterised in that it comprises at least one roller over which a metal wire stretched between a suply spool and a take-up spool passes, the said wire extending over the surface of the roller and forming the aforesaid electro-erosion tip parallel with its length.

12. An electric circuit produced by means of an electro-erosion tool (10) in a plate (2) carrying a thin conductive or semi-conductive coating deposited on an electrically insulating substrate, characterised in that it comprises a chemical compound which forms an electrical insulant and which is itself formed in the said thin coating and at the locations (5, 6) to which the electro-erosion tool has been applied.

13. An electric circuit according to Claim 12, characterised in that the thin coating consists of SnO₂ or ITO (indium oxide doped with tin) and in that the substrate consists of glass.

**Patentansprüche**

1. Verfahren zur Herstellung von elektrischen Schaltungen, die aus einer dünnen Leiter- oder Halbleiterschicht aufgebaut sind, die auf einem elektrisch isolierenden Substrat abgeschieden ist, wobei man von einer kontinuierlichen dünnen Schicht ausgeht, die auf dem Substrat abgeschieden ist und in der man danach durch eine Elektro-Erosionstechnik Schneid-, Ätz- oder Abtragungsvorgänge ausführt, um die Schaltung auszubilden, dadurch gekennzeichnet, daß man diese Schneid-, Ätz- oder Abtragungsvorgänge in einem Milieu bewirkt, dessen Zusammensetzung so gewählt ist, daß unter der Wirkung eines in diesem Milieu ausgebildeten elektrischen Mikro-Lichtbogens zwischen der Spitze eines Elektro-Erosionswerkzeuges (4) und der dünnen leitenden Schicht an dieser Stelle die Bildung einer neuen chemischen Verbindung stattfindet, die elektrisch isolierend ist.

2. Verfahren nach Anspruch 1, dadurch gekennzeichnet, daß das Milieu ein Elektrolyt oder eine dielektrische Flüssigkeit ist, welche die Bildung der chemischen Verbindung begünstigt.

3. Verfahren nach Anspruch 1 oder 2, dadurch gekennzeichnet, daß man das Substrat (2) und das Elektro-Erosionswerkzeug (4) relativ zueinander verschiebt, um das gewünschte Schaltungsmuster (5, 6) zu erhalten.

4. Verfahren nach einem der vorangegangenen Ansprüche, dadurch gekennzeichnet, daß man die Arbeitsspannung des Werkzeugs in Abhängigkeit vom elektrischen Widerstand pro Oberflächeneinheit der leitenden Schicht einstellt.

5. Verfahren nach einem der vorangegangenen Ansprüche, dadurch gekennzeichnet, daß man die Breite der Einritzungen oder Einschnitte, die vom Werkzeug in der dünnen Schicht erzeugt werden, durch die Wahl des elektrischen Widerstands pro Oberflächeneinheit der Schicht, die Form des Werkzeugs, seine Verschiebungsgeschwindigkeit und die Ätzspannung festlegt.

6. Verfahren nach einem der vorangegangenen Ansprüche, dadurch gekennzeichnet, daß man als dünne Schicht SnO₂ oder ITO (mit Zinn dotiertes Indiumoxid) verwendet.

7. Verfahren nach einem der vorangegangenen Ansprüche, dadurch gekennzeichnet, daß die dünne Schicht eine Dicke aufweist, die ungefähr zwischen $7 \times 10^{-5}$ mm und $8 \times 10^{-4}$ mm liegt.

8. Verfahren nach einem der vorangegangenen Ansprüche, dadurch gekennzeichnet, daß die dünne Schicht auf einem Glassubstrat abgeschieden wird.

9. Verfahren nach einem der vorangegangenen Ansprüche, dadurch gekennzeichnet, daß man als das vorerwähnte Milieu im wesentlichen Wasser einsetzt, dem gegebenenfalls etwas Äthanol zugegeben wird.

10. Verfahren nach einem der vorangegangenen Ansprüche, dadurch gekennzeichnet, daß man Arbeitsspannungen ungefähr zwischen 40 V und 150 V und Stromstärken einsetzt, die ungefähr zwischen 30 mA und 150 mA liegen.

11. Werkzeug zur Durchführung des Verfahrens nach einem der vorangegangenen Ansprüche, dadurch gekennzeichnet, daß es wenigstens eine Rolle umfaßt, auf der ein Metalldraht läuft, der zwischen einer Zuführspule und einer Aufnahmespule gespannt ist und über die Oberfläche der Rolle läuft, wobei er parallel zu seiner Länge die erwähnte Elektro-Erosionsspitze bildet.

12. Elektrischer Schaltkreis, der mit Hilfe eines Elektro-Erosionswerkzeuges (10) auf einer Platte (2) ausgebildet ist, die eine dünne Leiter- oder Halbleiterschicht aufweist, welche auf einem elektrisch isolierenden Substrat abgeschieden ist, dadurch gekennzeichnet, daß sie eine in der dünnen Schicht und an Stellen (5, 6), an denen das Elektro-Erosionswerkzeug zum Einsatz gekommen ist, ausgebildete chemische Verbindung umfaßt, die einen elektrischen Isolator bildet.

13. Elektrischer Schaltkreis nach Anspruch 12, dadurch gekennzeichnet, daß die dünne Schicht aus SnO₂ oder ITO (mit Zinn dotiertes Indiumoxid) zusammengesetzt ist und das Substrat aus Glas besteht.

FIG_1

FIG_3

FIG_2